(19) Europäisches Patentamt
European Patent Office
Office européen des brevets

(11) **EP 3 175 477 B1**

(12) **FASCICULE DE BREVET EUROPEEN**

(45) Date de publication et mention
de la délivrance du brevet:
**24.02.2021 Bulletin 2021/08**

(21) Numéro de dépôt: **15742368.2**

(22) Date de dépôt: **03.07.2015**

(51) Int Cl.:
***H01L 21/762*** *(2006.01)*

(86) Numéro de dépôt international:
**PCT/FR2015/051854**

(87) Numéro de publication internationale:
**WO 2016/016532 (04.02.2016 Gazette 2016/05)**

(54) **STRUCTURE POUR APPLICATIONS RADIO-FREQUENCES**

STRUKTUR FÜR RADIOFREQUENZANWENDUNGEN

STRUCTURE FOR RADIO-FREQUENCY APPLICATIONS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.08.2014 FR 1401800**

(43) Date de publication de la demande:
**07.06.2017 Bulletin 2017/23**

(73) Titulaire: **Soitec**
**38190 Bernin (FR)**

(72) Inventeurs:
• **KONONCHUK, Oleg**
**38570 Theys (FR)**
• **VAN DEN DAELE, William**
**38100 Grenoble (FR)**
• **DESBONNETS, Eric**
**38660 Lumbin (FR)**

(74) Mandataire: **IP Trust**
**2, rue de Clichy**
**75009 Paris (FR)**

(56) Documents cités:
**EP-A1- 0 969 522      EP-A2- 0 975 012
FR-A1- 2 977 070      US-A1- 2007 032 040
US-A1- 2013 294 038**

**Description**

**DOMAINE DE L'INVENTION**

La présente invention concerne le domaine des dispositifs radiofréquences intégrés.

**ARRIERE PLAN TECHNOLOGIQUE DE L'INVENTION**

Les dispositifs intégrés sont usuellement élaborés sur des substrats en forme de plaquettes qui servent principalement de support à leur fabrication. Toutefois, l'accroissement du degré d'intégration et des performances attendues de ces dispositifs entraine un couplage de plus en plus important entre leurs performances et les caractéristiques du substrat sur lequel ils sont formés. C'est particulièrement le cas des dispositifs radiofréquences (RF), traitant des signaux dont la fréquence est comprise entre environ 3kHz et 300GHz, qui trouvent notamment leur application dans le domaine des télécommunications (téléphonie cellulaire, Wi-Fi, Bluetooth...).

A titre d'exemple de couplage dispositif/substrat, les champs électromagnétiques, issus des signaux hautes fréquences se propageant dans les dispositifs, pénètrent dans la profondeur du substrat et interagissent avec les éventuels porteurs de charge qui s'y trouvent. Il s'en suit des problèmes de distorsion non linéaire (harmoniques) du signal, une consommation inutile d'une partie de l'énergie du signal par perte d'insertion et des influences possibles entre composants.

Ainsi, les dispositifs RF présentent des caractéristiques régies à la fois par leur architecture et procédés d'élaboration, et par la capacité du substrat sur lequel ils sont fabriqués à limiter les pertes d'insertion, les diaphonies entre dispositifs voisins, et les phénomènes de distorsion non linéaire générant des harmoniques.

Les dispositifs radiofréquences, tels que des commutateurs et adaptateurs d'antennes ainsi que des amplificateurs de puissance, peuvent être élaborés sur différents types de substrats.

On connaît par exemple les substrats silicium sur saphir, communément appelés SOS (pour « silicon on sapphire » selon l'appellation anglo-saxonne), qui font bénéficier les composants, élaborés selon des technologies microélectroniques dans la couche superficielle de silicium, des propriétés isolantes du substrat de saphir. Par exemple, les commutateurs d'antenne et amplificateurs de puissance fabriqués sur ce type de substrat présentent de très bons facteurs de mérite mais sont principalement utilisés pour des applications de niche du fait du coût global de la solution.

On connaît également les substrats à base de silicium haute résistivité comprenant un substrat support, une couche de piégeage disposée sur le substrat support, une couche diélectrique disposée sur la couche de piégeage, et une couche active de semi-conducteur disposée sur la couche diélectrique. Le substrat support présente habituellement une résistivité supérieure à 1 kOhm.cm. La couche de piégeage peut comprendre du silicium poly-cristallin non dopé. La combinaison d'un substrat support haute résistivité et d'une couche de piégeage selon l'état de l'art permet de réduire le couplage dispositif/substrat cité précédemment et ainsi d'assurer de bonnes performances des dispositifs RF. A cet égard, l'homme du métier trouvera une revue des performances des dispositifs RF fabriqués sur le substrat semi-conducteur haute résistivité connu de l'état de la technique dans « Silicon-on-insulator (SOI) Technology, manufacture and applications », points 10.7 et 10.8, Oleg Kononchuk et Bich-Yen Nguyen, chez Woodhead Publishing.

Néanmoins, une couche de piégeage en poly-silicium présente l'inconvénient de subir une recristallisation partielle lors des étapes de traitements thermiques à hautes températures, ce qui contribue à diminuer la densité de pièges dans la couche. L'évolution des normes de la téléphonie mobile imposant des spécifications de plus en plus exigeantes aux composants RF, la dégradation de la performance du dispositif liée à cette diminution de densité de pièges est rédhibitoire pour certaines applications.

Par ailleurs, les étapes de dépôt du poly-silicium et de préparation de surface en vue de la réalisation de l'empilement du substrat sont sensibles et dispendieuses.

Une alternative à cette couche de piégeage en poly-silicium est une couche en silicium poreux. Un dépôt d'une couche poreuse, selon l'art antérieur, ne permet pas d'obtenir une épaisseur de couche très fine, inférieure à 1 $\mu$m. Ainsi les couches poreuses de l'art antérieur et leur épaisseur, entre 10 $\mu$m et 80 $\mu$m, ne permettent pas d'obtenir un substrat comportant une couche poreuse dont la tenue mécanique est suffisante pour supporter certaines étapes de fabrication des dispositifs et être conservée dans les dispositifs fonctionnels Le document US 2013/294038 A1 divulgue une structure pour des applications radiofréquences comprenant un substrat support de silicium dont la partie supérieure comporte un couche de piégeage poreuse.

**OBJET DE L'INVENTION**

Un objet de l'invention est donc de proposer une structure adaptée pour les applications radiofréquences, remédiant aux inconvénients de l'art antérieur. Un objet de l'invention est notamment de proposer une structure intégrée répondant aux exigences croissantes des applications RF et permettant une réduction des couts de fabrication.

**BREVE DESCRIPTION DE L'INVENTION**

L'invention concerne une structure pour des applications radiofréquences comprenant :

- un substrat support de silicium haute résistivité comportant une partie inférieure et une partie supérieure ayant subi un dopage de type p sur une profondeur D ;
- une couche de piégeage mésoporeuse de silicium formée dans la partie supérieure dopée du substrat support ;

Selon l'invention, la structure est remarquable en ce que la profondeur D est inférieure à 1μm et la couche de piégeage présente un taux de porosité compris entre 20% et 60% , des pores dont le diamètre est compris entre 2 et 50 nm et une résistivité supérieure à 5000 ohm.cm.

Le taux de porosité de la couche de piégeage ainsi obtenue permet de contrôler précisément sa résistivité, à des niveaux pouvant être élevés (> 5000ohm.cm). Ainsi, le réglage du taux de porosité (selon une plage précise de 20% à 60%) et de la profondeur D (inférieure à 1μm) du dopage de la partie supérieure du substrat support de silicium dans laquelle sera formée la couche de piégeage, permettent :

- d'assurer une bonne tenue mécanique de la couche mésoporeuse, lui permettant d'être conservée dans le dispositif fonctionnel final ;
- et de conférer des propriétés de résistivité et d'isolation à la structure adéquates pour les applications radiofréquences.

Par ailleurs, la fabrication d'une couche de piégeage mésoporeuse très fine (inférieure à 1μm) simplifie l'étape de dépôt de la couche de piégeage sur le substrat support, ainsi que les potentielles étapes de préparation de surface nécessaires pour la réalisation d'étapes subséquentes de process.

Selon des caractéristiques avantageuses de l'invention, prises seules ou en combinaison :

- la couche de piégeage mésoporeuse présente des pores dont le diamètre est compris entre 2nm et 50nm ;
- la couche de piégeage mésoporeuse est obtenue par un procédé d'électrolyse de la partie supérieure dopée du substrat support ;
- le procédé d'électrolyse est contrôlé par une technique de contrôle de tension aux bornes de l'électrolyse ;
- la résistivité de la partie inférieure du substrat support est supérieure à 1000 Ohm.cm ;

Selon d'autres caractéristiques avantageuses de l'invention, prises seules ou en combinaison :

- une couche active est disposée sur la couche de piégeage ;
- la couche active est reportée sur la couche de piégeage par collage direct ;

- la couche active est formée d'un matériau semi-conducteur ;
- la couche active est formée d'un matériau piézoélectrique ;
- la couche active comprend au moins l'un des matériaux sélectionnés dans le groupe suivant : silicium, carbure de silicium, silicium germanium, niobate de lithium, tantalate de lithium, quartz, nitrure d'aluminium ;
- l'épaisseur de la couche active est comprise entre 10 nm et 50 μm ;
- une couche diélectrique est disposée entre la couche de piégeage et la couche active ;
- la couche diélectrique est reportée sur la couche de piégeage par collage direct ;
- la couche diélectrique comprend au moins un des matériaux sélectionné dans le groupe suivant: dioxyde de silicium, nitrure de silicium, oxyde d'aluminium ;
- la couche diélectrique est comprise entre 10 nm et 6 μm ;
- une couche de nitrure de silicium (SiN) est disposée entre la couche de piégeage et la couche diélectrique.

Selon d'autres caractéristiques avantageuses de l'invention, prises seules ou en combinaison, au moins un dispositif microélectronique est présent sur ou dans la couche active :

- le dispositif microélectronique est un circuit de commutation ou un circuit d'adaptation d'antenne ou un circuit d'amplification de puissance radiofréquence ;
- le dispositif microélectronique comprend une pluralité de composants actifs et une pluralité de composants passifs ;
- le dispositif microélectronique comprend au moins un élément de commande et un élément de commutation MEMS consistant en un micro-commutateur à contact ohmique ou en un micro-commutateur capacitif ;
- le dispositif microélectronique est un filtre radiofréquence fonctionnant par propagation d'ondes acoustiques de volume ou de surface.

**BREVE DESCRIPTION DES DESSINS**

D'autres caractéristiques et avantages de l'invention ressortiront de la description détaillée de l'invention qui va suivre en référence aux figures annexées sur lesquelles :

- la figure 1 représente la dépendance du module d'Young avec la porosité du silicium ;

- la figure 2 représente un premier mode de réalisation de l'invention ;

- les figures 3a et 3b représentent un deuxième mode de réalisation de l'invention ;

- la figure 4 représente un autre mode de réalisation de l'invention ;

## DESCRIPTION DETAILLEE DE L'INVENTION

La structure 1,1',11 pour applications radiofréquences selon l'invention comprend un substrat support 2 de silicium haute résistivité (HR). Par haute résistivité, on entend une résistivité supérieure à 1000ohm.cm ; elle est avantageusement comprise entre 4000 et 10000ohm.cm.

Le substrat support 2 de silicium HR subit un dopage de type p sur une partie supérieure 3 et une profondeur prédéterminée D, inférieure à 1μm, conformément à l'invention. Ce dopage peut être avantageusement réalisé par une implantation ionique suivie d'un recuit de type RTA pour activer les dopants de type p implantés, ou une épitaxie d'une couche p+, ou encore un dopage par « spin on glass » (terminologie anglo-saxonne pour un dépôt d'une couche de verre par centrifugation).

Ainsi dopée la couche supérieure 3 du substrat support 2 de silicium HR est soumise à un procédé d'électrolyse, de manière à transformer la partie supérieure 3 du substrat support 2 en une couche poreuse 4, qui constituera la couche de piégeage 4. La profondeur D des éléments dopants introduits préalablement dans la partie supérieure 3 du substrat support 2 correspond sensiblement à l'épaisseur de la couche de piégeage 4.

Le procédé d'électrolyse peut consister par exemple en une anodisation électrochimique, dans laquelle au moins la partie supérieure 3 du substrat support 2 est placée dans une enceinte comprenant un électrolyte, tel que l'acide fluorhydrique. Une anode et une cathode sont alors plongées dans l'électrolyte et alimentées par une source de courant électrique.

Il existe trois types de morphologies pour du silicium poreux :

- le silicium macroporeux, généralement obtenu à partir de silicium de type n faiblement dopé, et présentant un diamètre de pores supérieur à 50nm ;
- le silicium mésoporeux, généralement obtenu à partir de silicium de type p fortement dopé, et présentant un diamètre de pores compris entre 2nm et 50nm ;
- le silicium nanoporeux (ou encore appelé microporeux), généralement obtenu à partir de silicium de type p faiblement dopé, et présentant un diamètre de pores inférieur à 2nm.

Ainsi, selon le niveau de dopage du substrat 2 et les conditions du procédé d'électrolyse, tel que l'ajustement de la densité de courant électrique appliqué par la source de courant électrique, le taux de porosité sera plus ou moins important et contrôlé. Pour rappel, la porosité Po d'une couche est définie comme la fraction de volume inoccupé au sein de la couche et s'écrit :

$$Po = (d - d_{Po}) / d$$

où d est la densité du matériau non-poreux et $d_{Po}$ est la densité du matériau poreux.

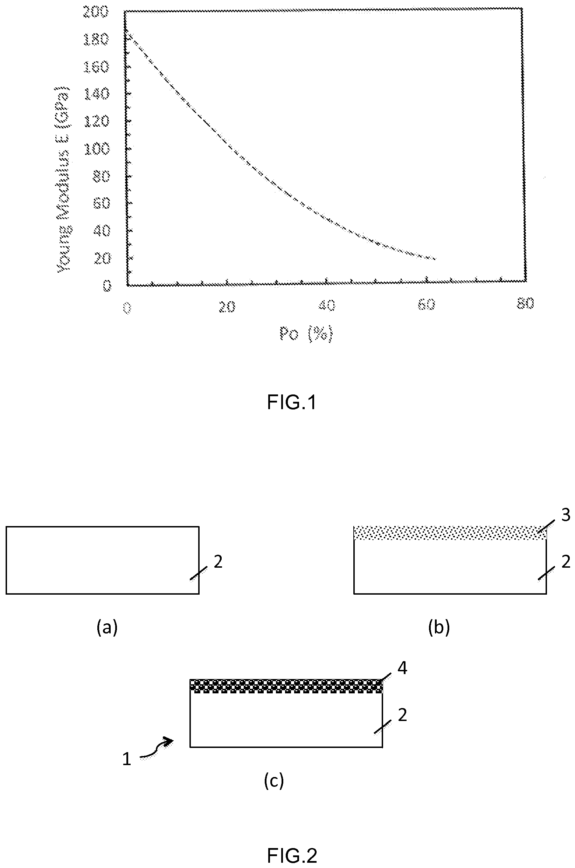

La couche de piégeage 4 générée doit posséder un taux de porosité suffisant pour obtenir une densité de défauts élevée, apte à piéger les charges d'inversion générées dans le substrat support 2, et un niveau de résistivité élevé. Mais ce taux de porosité, couplé à l'épaisseur de la couche poreuse 4, caractérise également la tenue mécanique de la couche de piégeage 4. La dépendance du module d'Young (noté E et exprimé en GigaPascal) en fonction du taux de porosité de la couche poreuse est représentée sur la figure 1. Pour une épaisseur donnée, plus le taux de porosité est important, plus les propriétés mécaniques sont faibles : la décroissance du module d'Young en fonction du pourcentage de porosité (Po) traduit cette diminution de la tenue mécanique. De plus, pour un taux de porosité donné, plus la couche poreuse est épaisse, plus les propriétés mécaniques sont faibles. La demanderesse a identifié une fenêtre de procédé pour laquelle la couche poreuse présente la résistance mécanique requise pour être compatible avec des étapes subséquentes microélectroniques (dépôt, recuits, polissage...) ainsi que les propriétés de résistivité requises pour les applications radiofréquences.

La structure 1,1',11 selon l'invention propose donc une couche de piégeage 4 dont le taux de porosité est compris entre 20% et 60% et dont l'épaisseur est inférieure à 1μm, de manière à assurer des performances mécaniques et électriques de la structure 1,1',11. La morphologie mésoporeuse, présentant des pores d'un diamètre compris entre 2nm et 50nm permet d'atteindre les niveaux requis de porosité, sur l'épaisseur de 1μm, avec une densité importante de pièges (typiquement supérieure à $10^{13}$/cm2, permettant de piéger les charges d'inversion) et une haute résistivité.

L'épaisseur D de la couche de piégeage 4 (en silicium mésoporeux) dépend de la profondeur du dopage de type p de la partie supérieure 3 du substrat support 2. Le taux de porosité dépend de la quantité d'éléments dopants introduits dans la partie supérieure 3 du substrat support 2 ainsi que des conditions de réalisation du procédé d'électrolyse.

Afin de s'assurer que la porosification par électrolyse de la partie supérieure 3 du substrat support 2 ne dépasse pas la profondeur prédéterminée D, un contrôle de la tension aux bornes de l'électrolyse est mis en place, permettant de déterminer lorsque la porosification débute dans la partie inférieure non dopée du substrat support 2 en silicium HR, et donc d'arrêter le procédé d'électrolyse. La porosification de la partie supérieure 3 du substrat support 2 doit s'arrêter à la fin de la queue de diffusion des dopants introduits dans la partie supérieure 3 du substrat 2, sensiblement à la profondeur D.

La structure 1,1',11 pour applications radiofréquences selon l'invention comprend ainsi une couche de piégeage 4 en silicium mésoporeux, dont la porosité est comprise entre 20 et 60% et dont l'épaisseur est inférieure à 1$\mu$m, disposée sur un substrat support 2 de silicium haute résistivité. La couche de piégeage a une résistivité typique supérieure à 5000ohm.cm.

Selon un premier mode de réalisation de l'invention représenté sur la figure 2, la structure 1 pour applications radiofréquences peut prendre la forme d'une plaquette de dimensions compatibles avec des procédés microélectroniques, par exemple de diamètre 200mm ou 300mm, comprenant le substrat support 2 et la couche de piégeage 4 (figure 2c).

Le substrat support 2 de silicium HR (figure 2a) a avantageusement une résistivité supérieure à 4000ohm.cm. Il subit d'abord une implantation ionique de bore, par exemple, à une dose de 1$^e$13/cm2 et à une énergie de 50keV, suivie d'un traitement thermique à 1000°C pendant 5 minutes ; une partie supérieure 3 dopée p, sur une profondeur d'environ 200nm est ainsi créée (figure 2b). Le substrat support 2 subit ensuite une électrolyse : la densité de courant sera par exemple comprise entre 10 et 20mA/cm$^2$ et la solution d'électrolyse aura une concentration HF comprise entre 10 et 30%. La couche de piégeage 4 mésoporeuse de silicium est formée, dans la partie supérieure dopée 3 du substrat support 2 (figure 2c). La porosité obtenue, dépendante de la quantité d'éléments dopants et de la densité de courant appliquée pendant l'électrolyse, est de l'ordre de 50% ; les pores ont une taille comprise entre 2 et 50nm. Ce mode de fabrication, simple et peu dispendieux, permet l'obtention d'une structure 1 présentant des propriétés mécaniques et électriques compatibles avec les spécifications des applications radiofréquences :

- une bonne tenue mécanique permettant de résister aux différentes étapes contraignantes d'élaboration de composants microélectroniques ;
- des propriétés d'isolation stables liées à la haute résistivité du substrat support 2 et aux qualités de piégeage des charges de la couche de piégeage 4 mésoporeuse, même après application des traitements thermiques à hautes températures pour l'élaboration de composants microélectroniques.

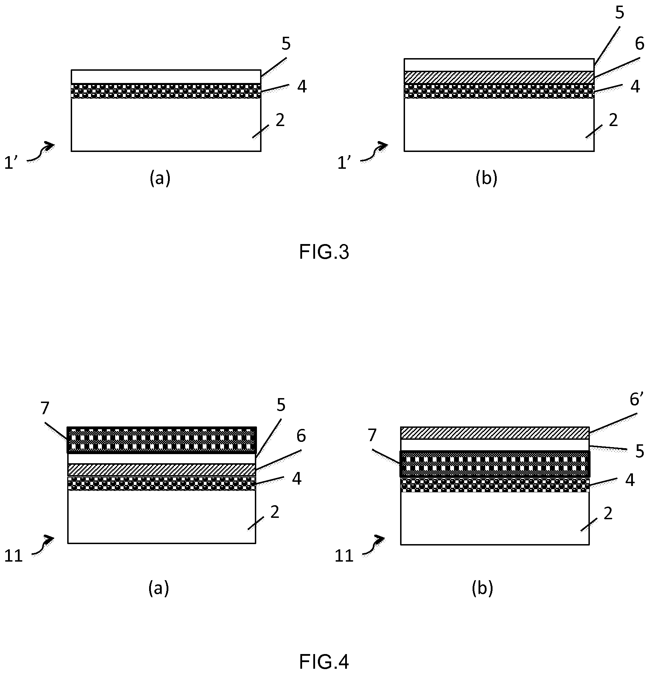

Un deuxième mode de réalisation de l'invention est représenté en figure 3. Selon une première variante de ce deuxième mode de réalisation, illustré en figure 3a, la structure 1' pour applications radiofréquences peut prendre la forme d'une plaquette et comporter en outre une couche active 5, disposée sur la couche de piégeage 4, dans et sur laquelle des composants RF pourront être élaborés. La couche active 5 pourra avantageusement être constituée de matériaux semi-conducteurs et/ou de matériaux piézoélectriques. Avantageusement, sans toutefois que cela soit limitatif, la couche active 5 comprend au moins l'un des matériaux parmi : silicium, carbure de silicium, silicium germanium, niobate de lithium, tantalate de lithium, quartz, nitrure d'aluminium... L'épaisseur de la couche active 5 peut varier de quelques nanomètres (par exemple 10nm) à plusieurs dizaines de microns (par exemple 50$\mu$m) selon les composants à fabriquer.

A titre d'exemple, la couche active 5 est reportée sur le substrat support 2 comportant la couche de piégeage 4, par un des procédés de transfert de couches minces bien connus de l'homme du métier, parmi lesquels :

- le procédé Smart Cut™, basé sur une implantation d'ions légers d'hydrogène et/ou d'hélium dans un substrat donneur et un collage par exemple par adhésion moléculaire de ce substrat donneur directement sur la couche de piégeage 4, elle-même disposée sur le substrat support 2 ; une étape de détachement permet ensuite de séparer une couche mince superficielle du substrat donneur (la couche active), au niveau du plan de fragilisation défini par la profondeur d'implantation des ions. Des étapes de finition, pouvant inclure des traitements thermiques à haute température, confèrent enfin la qualité cristalline et de surface requise à la couche active 5. Ce procédé est particulièrement adapté pour la fabrication de couches actives minces, d'épaisseur comprise entre quelques nanomètres et environ 1,5$\mu$m par exemple pour les couches de silicium.
- le procédé Smart Cut suivi d'une étape d'épitaxie, permettant notamment d'obtenir des couches actives plus épaisses, par exemple de quelques dizaines de nm à 20$\mu$m.
- les procédés de collage direct et d'amincissements mécanique, chimique et/ou mécano-chimique ; ils consistent à assembler un substrat donneur par adhésion moléculaire directement sur la couche de piégeage 4, elle-même disposée sur le substrat support 2, puis à amincir le substrat donneur jusqu'à l'épaisseur souhaitée de couche active 5, par exemple par rodage (« grinding » selon la terminologie anglo-saxonne) et par polissage (CMP pour « chemical mechanical polishing »). Ces procédés sont particulièrement adaptés au report de couches épaisses, par exemple de quelques microns à plusieurs dizaines de microns, et jusqu'à quelques centaines de microns.

Selon une autre variante du deuxième mode de réalisation, représentée en figure 3b, la structure 1' pour applications radiofréquences pourra également comporter une couche diélectrique 6, disposée entre la couche active 5 et la couche de piégeage 4. Avantageusement, sans toutefois que cela soit limitatif, la couche diélectrique 6 comprendra au moins l'un des matériaux parmi :

dioxyde de silicium, nitrure de silicium, oxyde d'aluminium... Son épaisseur pourra varier entre 10nm et 3μm.

La couche diélectrique 6 est obtenue par oxydation thermique ou par dépôt LPCVD ou PECVD ou HDP, sur la couche de piégeage 4 ou sur le substrat donneur préalablement au report de la couche active 5 sur la couche de piégeage 4.

Comme bien connu dans le domaine des substrats SOI (pour « silicon on insulator ») pour les applications radiofréquences, une telle couche diélectrique, par exemple formée par un oxyde de silicium sur un substrat support de silicium, comporte des charges positives. Ces charges sont compensées par des charges négatives venant du substrat support, au niveau de l'interface avec la couche diélectrique. Ces charges génèrent une couche de conduction dans le substrat support, sous la couche diélectrique, dont la résistivité chute autour de 10-100ohm.cm. Les performances électriques sensibles à la résistivité du substrat support (comme la linéarité du signal, le niveau de pertes d'insertion, les facteurs de qualité des composants passifs, ...) sont donc fortement dégradés par la présence de cette couche de conduction.

Le rôle de la couche de piégeage 4 est alors de piéger toutes les charges mobiles générées dans le substrat support 2 afin qu'il conserve un niveau de résistivité haut et stable.

La figure 4 présente un troisième mode de réalisation conforme à l'invention. Selon une première variante de ce troisième mode de réalisation, représenté sur la figure 4a, la structure 11 pour applications radiofréquences peut également comporter ou consister en un dispositif microélectronique 7 sur ou dans la couche active 5, laquelle est disposée sur une couche diélectrique 6 ou directement sur la couche de piégeage 4. Le dispositif microélectronique 7 peut être un circuit de commutation (appelé « switch » selon la terminologie anglosaxonne) ou un circuit d'adaptation ou de syntonisation d'antenne (appelé « tuner » selon la terminologie anglosaxonne) ou encore un circuit d'amplification de puissance (appelé « power amplifier » selon la terminologie anglo-saxonne), élaboré selon les technologies microélectroniques silicium. La couche active 5 en silicium a typiquement une épaisseur comprise entre 50nm et 180nm, par exemple 145nm, et la couche diélectrique 6 sous-jacente a une épaisseur comprise entre 50nm et 400nm, par exemple 200nm ; la couche de piégeage 4 est disposée entre la couche diélectrique 6 et le substrat support 2. Le dispositif microélectronique 7 élaboré dans et sur la couche active 5 comprend une pluralité de composants actifs (de type MOS, bipolaires, ...) et une pluralité de composants passifs (de type capacités, inductances, résistances, résonateurs, filtres,...) .

La fabrication des composants microélectroniques nécessite la réalisation de plusieurs étapes dont des traitements thermiques à hautes températures, typiquement à 950-1100°C, voire au-delà. La couche de piégeage 4 en silicium mésoporeux décrite précédemment, conserve ses propriétés physiques et électriques après de tels traitements thermiques.

Selon une autre variante de ce mode de réalisation, représentée sur la figure 4b, le dispositif microélectronique 7 peut être d'abord élaboré sur un substrat de type SOI (pour « silicon on insulator » selon la terminologie anglo-saxonne), puis reporté par une technique de transfert de couches connue de l'homme du métier, sur une structure 1 selon l'invention comportant la couche de piégeage 4 disposée sur le substrat support 2.

Dans ce cas de figure, la structure 11 comprend d'une part le substrat support 2 sur lequel est disposée la couche de piégeage 4 ; au-dessus de cette dernière, se présente la couche de composants du dispositif microélectronique 7 : la partie dite « back end » de couches d'interconnexions métalliques et de diélectriques est disposée au-dessus de la couche de piégeage 4, la partie dite « front end » (silicium), élaborée en partie dans la couche active 5, étant elle-même au-dessus de la partie « back-end ». Enfin, on trouve au-dessus la couche active 5 et optionnellement une couche diélectrique 6'.

Dans les deux cas de figures, les champs électromagnétiques, issus des signaux hautes fréquences destinés à se propager dans les dispositifs 7, et qui vont pénétrer dans la couche de piégeage 4 et dans le substrat support 2, ne subiront que de faibles pertes (pertes d'insertion) et perturbations (diaphonie, harmoniques), du fait de la résistivité haute et stable du substrat support 2 et de la couche de piégeage 4. De manière avantageuse, la structure 11 selon l'invention bénéficie d'un procédé de fabrication de la couche de piégeage 4 simple et économique comparé à l'état de l'art ; et elle offre des performances au moins équivalentes.

Selon un quatrième mode de réalisation, la structure 11 pour applications radiofréquences peut comporter ou consister en un dispositif microélectronique 7 comprenant au moins un élément de commande et un élément de commutation MEMS (microsystèmes électromécaniques, soit « microelectromechanical systems » selon l'appellation anglo-saxonne) consistant en un microcommutateur à contact ohmique ou en un microcommutateur capacitif.

La fabrication de MEMS peut être facilitée par la présence d'une couche diélectrique sous une couche active de silicium. La structure 11 selon l'invention pourra donc comporter, à titre d'exemple, une couche active 5 en silicium d'épaisseur comprise entre 20 nm et 2 microns, avantageusement 145 nm, et une couche diélectrique 6 sous-jacente d'épaisseur comprise entre 20 nm et 1 micron, avantageusement 400 nm ; la couche de piégeage 4 est disposée entre la couche diélectrique 6 et le substrat support 2. La fabrication de la partie MEMS est ensuite basée sur des techniques de micro-usinage de surface, permettant en particulier la libération de poutres ou de membranes mobiles dans la couche active de silicium.

De manière alternative, la partie MEMS peut être élaborée directement sur la couche de piégeage 4, par dépôt successif d'une pluralité de couches (incluant une électrode, un diélectrique, une couche sacrificielle, une couche active) et par la réalisation de motifs sur ces différentes couches.

Les procédés microélectroniques pour la fabrication du ou des élément(s) de commande (CMOS par exemple), habituellement réalisée avant la partie MEMS, requièrent, comme dans le mode de réalisation précédent, l'application de traitements thermiques à hautes températures. La résistance mécanique de la couche de piégeage 4 à ce type de traitement ainsi que sa capacité à conserver ses propriétés électriques (résistivité élevée et densité de pièges aptes à piéger les charges mobiles) sont donc des avantages clés.

De la même manière que pour le troisième mode de réalisation, les signaux hautes fréquences se propageant dans ce dispositif 7 génèrent des champs électromagnétiques qui pénètrent dans la couche de piégeage 4 et dans le substrat support 2. Les pertes (pertes d'insertion), distorsions (harmoniques) et perturbations (diaphonie,...) seront moindres du fait de la résistivité haute et stable du substrat support 2 muni de la couche de piégeage 4.

Selon un cinquième mode de réalisation, la structure 11 pour applications radiofréquences peut comporter ou consister en un dispositif microélectronique 7 comprenant un filtre radiofréquence fonctionnant par propagation d'onde acoustique de volume (appelé « BAW » pour « Bulk Acoustic Wave » selon l'appellation anglo-saxonne).

La fabrication d'un filtre BAW de type FBAR (pour « thin-Film Bulk Acoustic Resonator » selon la terminologie anglo-saxonne) nécessite une couche active 5 constituée d'un matériau piézoélectrique, dans laquelle sera confinée l'onde acoustique entre les deux électrodes qui l'entourent. La structure 11 selon l'invention pourra donc comporter, à titre d'exemple, une couche active 5 de nitrure d'aluminium d'épaisseur comprise entre 50 nm et 1 $\mu$m, avantageusement 100 nm, et une couche diélectrique 6 (par exemple d'oxyde de silicium) dont l'épaisseur est comprise entre 1 et 6 $\mu$m ; la couche de piégeage 4 est disposée entre la couche diélectrique 6 et le substrat support 2. Des cavités d'isolation sont aménagées sous les zones actives du filtre, c'est-à-dire les zones dans lesquelles les ondes acoustiques seront amenées à se propager.

La fabrication du filtre BAW nécessite ensuite des étapes de dépôts d'électrodes au niveau desquelles sera appliqué le signal RF.

La structure 11 selon l'invention permet d'une part de limiter la profondeur des cavités d'isolation dont la fonction d'isolation par rapport au substrat est rendue moins critique par la résistivité haute et stable du substrat support et de la couche de piégeage ; c'est un avantage en terme de simplification, flexibilité et robustesse de procédé de fabrication de ces dispositifs. D'autre part, la structure 11 selon l'invention permet l'obtention de meilleures performances des filtres, notamment en terme de linéarité.

Selon une variante de ce cinquième mode de réalisation, le dispositif microélectronique 7 comprend un filtre radiofréquence fonctionnant par propagation d'onde acoustique de surface (appelé « SAW » pour « Surface Acoustic Wave » selon l'appellation anglo-saxonne).

La fabrication d'un filtre SAW nécessite une couche active 5 constituée d'un matériau piézoélectrique, à la surface de laquelle sera élaboré un peigne d'électrodes : l'onde acoustique est destinée à se propager entre ces électrodes. La structure 11 selon l'invention pourra donc comporter, à titre d'exemple, une couche active 5 de tantalate de lithium d'épaisseur comprise entre 200 nm et 20 $\mu$m, avantageusement 0,6 $\mu$m ; la couche de piégeage 4 est disposée entre la couche active 5 et le substrat support 2. Une couche diélectrique 6 peut optionnellement être ajoutée entre la couche active 5 et la couche de piégeage 4.

La structure 11 selon l'invention permet l'obtention de meilleures performances de filtres, notamment en terme de pertes d'insertion et de linéarité.

La structure 1,1', 11 pour applications radiofréquences selon l'invention n'est pas limitée aux modes de réalisation cités ci-dessus. Elle est adaptée à toute application pour laquelle des signaux hautes fréquences se propagent et sont susceptibles de subir des pertes ou des perturbations non souhaitées dans un substrat support, car les caractéristiques physiques et électriques de la couche de piégeage 4 disposée sur le substrat support 2 confèrent à l'ensemble de bonnes propriétés RF (limitant les pertes, non linéarités et autres perturbations).

**Revendications**

1. Structure (1,1', 11) pour des applications radiofréquences comprenant :

   • un substrat support (2) de silicium comportant une partie inférieure et une partie supérieure (3);
   • une couche de piégeage (4) poreuse de silicium formée dans la partie supérieure (3) du substrat support (2) ; la structure (1,1', 11) étant **caractérisée en ce que** :
   • le substrat support (2) est constitué de silicium haute résistivité, présentant une résistivité supérieure à 1000 Ohm.cm, et la partie supérieure (3) présente un dopage de type p sur une profondeur D inférieure à 1 micron ;
   • la couche de piégeage (4), formée dans la partie supérieure (3) dopée du substrat support (2), est mésoporeuse, avec des pores dont le diamètre est compris entre 2nm et 50nm, et présente un taux de porosité compris entre 20% et 60% et une résistivité supérieure à 5000 Ohm.cm;

2. Structure (1,1', 11) pour des applications radiofréquences selon la précédente revendication, dans laquelle une couche active (5) est disposée sur la couche de piégeage (4) .

3. Structure (1,1',11) pour des applications radiofréquences selon la revendication précédente, dans laquelle la couche active (5) est formée d'un matériau semi-conducteur.

4. Structure (1,1', 11) pour des applications radiofréquences selon la revendication 2, dans laquelle la couche active (5) est formée d'un matériau piézoélectrique.

5. Structure (1,1', 11) pour des applications radiofréquences selon la revendication 2, dans laquelle la couche active (5) comprend au moins l'un des matériaux sélectionnés dans le groupe suivant : silicium, carbure de silicium, silicium germanium, niobate de lithium, tantalate de lithium, quartz, nitrure d'aluminium.

6. Structure (1,1',11) pour des applications radiofréquences selon l'une des revendications 2 à 5, dans laquelle l'épaisseur de la couche active (5) est comprise entre 10 nm et 50 $\mu$m.

7. Structure (1,1',11) pour des applications radiofréquences selon l'une des revendications 2 à 6, dans laquelle une couche diélectrique (6) est disposée entre la couche de piégeage (4) et la couche active (5).

8. Structure (1,1', 11) pour des applications radiofréquences selon la revendication précédente, dans laquelle la couche diélectrique (6) comprend au moins un des matériaux sélectionné dans le groupe suivant: dioxyde de silicium, nitrure de silicium, oxyde d'aluminium.

9. Structure (1,1',11) pour des applications radiofréquences selon l'une des revendications 7 ou 8, dans laquelle la couche diélectrique (6) est comprise entre 10 nm et 6 $\mu$m.

10. Structure (1,1',11) pour des applications radiofréquences selon l'une des revendications 2 à 9, dans laquelle au moins un dispositif microélectronique (7) est présent sur ou dans la couche active (5), le dispositif microélectronique (7) étant un circuit de commutation ou un circuit d'adaptation d'antenne ou un circuit d'amplification de puissance radiofréquence.

11. Structure (1,1', 11) pour des applications radiofréquences selon l'une des revendications 2 à 9, dans laquelle au moins un dispositif microélectronique (7) est présent sur ou dans la couche active (5), le dispositif microélectronique (7) comprenant une pluralité de composants actifs et une pluralité de composants passifs.

12. Structure (1,1', 11) pour des applications radiofréquences selon l'une des revendications 2 à 9, dans laquelle au moins un dispositif microélectronique (7) est présent sur ou dans la couche active (5), le dispositif microélectronique (7) comprenant au moins un élément de commande et un élément de commutation MEMS consistant en un micro-commutateur à contact ohmique ou en un micro-commutateur capacitif.

13. Structure (1,1', 11) pour des applications radiofréquences selon l'une des revendications 2 à 9, dans laquelle au moins un dispositif microélectronique (7) est présent sur ou dans la couche active (5), le dispositif microélectronique (7) étant un filtre radiofréquence fonctionnant par propagation d'ondes acoustiques de volume ou de surface.

**Patentansprüche**

1. Struktur (1,1 ',11) für Hochfrequenzanwendungen, umfassend:

   • ein Trägersubstrat (2) aus Silicium, umfassend einen unteren Teil und einen oberen Teil (3);
   • eine poröse Einfangschicht (4) aus Silicium, die im oberen Teil (3) des Trägersubstrats (2) gebildet ist; wobei die Struktur (1,1',11) **dadurch gekennzeichnet ist, dass**:
   • das Trägersubstrat (2) aus hochohmigem Silicium mit einem spezifischen Widerstand von mehr als 1000 $\Omega$ cm besteht, und der obere Teil (3) eine p-Dotierung in einer Tiefe D von weniger als 1 Mikrometer aufweist;
   • die Einfangschicht (4), die im dotierten oberen Teil (3) des Trägersubstrats (2) gebildet ist, mesoporös mit Poren ist, deren Durchmesser zwischen 2 nm und 50 nm liegt, und einen Porositätsgrad zwischen 20 % auf und 60 % und einen spezifischen Widerstand von mehr als 5000 $\Omega$ cm aufweist;

2. Struktur (1,1 ',11) für Hochfrequenzanwendungen nach dem vorhergehenden Anspruch, wobei eine aktive Schicht (5) auf der Einfangschicht (4) angeordnet ist.

3. Struktur (1,1 ',11) für Hochfrequenzanwendungen nach dem vorhergehenden Anspruch, wobei die aktive Schicht (5) aus einem Halbleitermaterial gebildet ist.

4. Struktur (1,1 ',11) für Hochfrequenzanwendungen nach Anspruch 2, wobei die aktive Schicht (5) aus einem piezoelektrischen Material gebildet ist.

**5.** Struktur (1,1 ',11) für Hochfrequenzanwendungen nach Anspruch 2, wobei die aktive Schicht (5) mindestens eines der aus der folgenden Gruppe ausgewählten Materialien umfasst:
Silicium, Siliciumcarbid, Siliciumgermanium, Lithiumniobat, Lithiumtantalat, Quarz, Aluminiumnitrid.

**6.** Struktur (1,1 ',11) für Hochfrequenzanwendungen nach einem der Ansprüche 2 bis 5, wobei die Dicke der aktiven Schicht (5) zwischen 10 nm und 50 µm liegt.

**7.** Struktur (1,1 ',11) für Hochfrequenzanwendungen nach einem der Ansprüche 2 bis 6, wobei eine dielektrische Schicht (6) zwischen der Einfangschicht (4) und der aktiven Schicht (5) angeordnet ist.

**8.** Struktur (1,1 ',11) für Hochfrequenzanwendungen nach dem vorhergehenden Anspruch, wobei die dielektrische Schicht (6) mindestens eines der aus der folgenden Gruppe ausgewählten Materialien umfasst:
Siliciumdioxid, Siliciumnitrid, Aluminiumoxid.

**9.** Struktur (1,1 ',11) für Hochfrequenzanwendungen nach einem der Ansprüche 7 oder 8, wobei die dielektrische Schicht (6) zwischen 10 nm und 6 µm liegt.

**10.** Struktur (1,1 ',11) für Hochfrequenzanwendungen nach einem der Ansprüche 2 bis 9, wobei mindestens eine mikroelektronische Vorrichtung (7) auf oder in der aktiven Schicht (5) vorhanden ist, wobei die mikroelektronische Vorrichtung (7) eine Schaltschaltung oder eine Antennenanpassungsschaltung oder eine Hochfrequenz-Leistungsverstärkungsschaltung ist.

**11.** Struktur (1,1 ',11) für Hochfrequenzanwendungen nach einem der Ansprüche 2 bis 9, wobei mindestens eine mikroelektronische Vorrichtung (7) auf oder in der aktiven Schicht (5) vorhanden ist, wobei die mikroelektronische Vorrichtung (7) eine Vielzahl aktiver Komponenten und eine Vielzahl passiver Komponenten umfasst.

**12.** Struktur (1,1',11) für Hochfrequenzanwendungen nach einem der Ansprüche 2 bis 9, bei der mindestens eine mikroelektronische Vorrichtung (7) auf oder in der aktiven Schicht (5) vorhanden ist, wobei die mikroelektronische Vorrichtung (7) mindestens ein Steuerelement und ein MEMS-Schaltelement, bestehend aus einem Mikroschalter mit ohmschen Kontakt oder einem kapazitiven Mikroschalter, umfasst.

**13.** Struktur (1,1 ',11) für Hochfrequenzanwendungen nach einem der Ansprüche 2 bis 9, wobei mindestens eine mikroelektronische Vorrichtung (7) auf oder in der aktiven Schicht (5) vorhanden ist, wobei die mikroelektronische Vorrichtung (7) ein Hochfrequenzfilter ist, der durch Ausbreitung von akustischen Volumen- oder Oberflächenwellen arbeitet.

**Claims**

**1.** Structure (1, 1', 11) for radio frequency applications comprising:

• a silicon support substrate (2) having a lower part and an upper part (3);
• a porous silicon trapping layer (4) formed in the upper part (3) of the support substrate (2); the structure (1, 1', 11) being **characterized in that**:
• the support substrate (2) is made of high-resistivity silicon, having a resistivity greater than 1000 Ohm.cm, and the upper part (3) has a p-type doping to a depth D of less than 1 micron;
• the trapping layer (4), formed in the doped upper part (3) of the support substrate (2), is mesoporous, with pores the diameter of which is between 2 nm and 50 nm, and has a porosity rate of between 20% and 60% and a resistivity greater than 5000 Ohm.cm;

**2.** Structure (1, 1', 11) for radio frequency applications according to the preceding claim, wherein an active layer (5) is arranged on the trapping layer (4).

**3.** Structure (1, 1', 11) for radio frequency applications according to the preceding claim, wherein the active layer (5) is formed from a semiconductor material.

**4.** Structure (1, 1', 11) for radio frequency applications according to claim 2, wherein the active layer (5) is formed from a piezoelectric material.

**5.** Structure (1, 1', 11) for radio frequency applications according to claim 2, wherein the active layer (5) comprises at least one of the materials selected from the following group:
silicon, silicon carbide, silicon germanium, lithium niobate, lithium tantalate, quartz, aluminum nitride.

**6.** Structure (1, 1', 11) for radio frequency applications according to any of claims 2 to 5, wherein the thickness of the active layer (5) is between 10 nm and 50 µm.

**7.** Structure (1, 1', 11) for radio frequency applications according to any of claims 2 to 6, wherein a dielectric layer (6) is arranged between the trapping layer (4) and the active layer (5).

**8.** Structure (1, 1', 11) for radio frequency applications according to the preceding claim, wherein the dielectric layer (6) comprises at least one of the materials selected from the following group: silicon dioxide, silicon nitride, aluminum oxide.

9. Structure (1, 1', 11) for radio frequency applications according to either claim 7 or claim 8, wherein the dielectric layer (6) is between 10 nm and 6 μm.

10. Structure (1, 1', 11) for radio frequency applications according to any of claims 2 to 9, wherein at least one microelectronic device (7) is present on or in the active layer (5), the microelectronic device (7) being a switching circuit or an antenna matching circuit or a radio frequency power amplification circuit.

11. Structure (1, 1', 11) for radio frequency applications according to any of claims 2 to 9, wherein at least one microelectronic device (7) is present on or in the active layer (5), the microelectronic device (7) comprising a plurality of active components and a plurality of passive components.

12. Structure (1, 1', 11) for radio frequency applications according to any of claims 2 to 9, wherein at least one microelectronic device (7) is present on or in the active layer (5), the microelectronic device (7) comprising at least one control element and one MEMS switching element consisting of an ohmic contact microswitch or a capacitive microswitch.

13. Structure (1, 1', 11) for radio frequency applications according to any of claims 2 to 9, wherein at least one microelectronic device (7) is present on or in the active layer (5), the microelectronic device (7) being a radio frequency filter operating by propagation of volume or surface acoustic waves.

FIG.1

(a)

(b)

(c)

FIG.2

FIG.3

FIG.4

**EP 3 175 477 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2013294038 A1